# EUROPÄISCHE PATENTSCHRIFT

(11) **EP 0 419 694 B1**
(45) Veröffentlichungstag und Bekanntmachung des Hinweises auf die Patenterteilung: **13.07.1994**
(21) Anmeldenummer: 89117695.0
(22) Anmeldetag: 25.09.1989
(51) Int. Cl.: H05K 7/14

(54) **Baugruppen zum Anschluss an einen Baugruppenträger**
Modules for connection to a module support
Module électronique à connecter à un support

(43) Veröffentlichungstag der Anmeldung: 03.04.1991
(73) Patentinhaber: SIEMENS AKTIENGESELLSCHAFT, 80333 München (DE)
(72) Erfinder: Deinhardt, Günther, Dipl.-Ing.(FH), D-8450 Amberg (DE); Schirbl, Reinhard, D-8460 Schwandorf (DE)

(56) Entgegenhaltungen:
- EP-A- 0 067 757
- WO-A-88/08662
- DE-U- 8 903 468
- US-A- 4 152 750

## Beschreibung

Die Erfindung bezieht sich auf eine, an einen Baugruppenträger anschließbare, kastenförmige, aus zumindest einer Gehäuseschale und einem Abdeckteil bestehende Baugruppe mit einer Leiterplatte, an der zur Anschlußseite der Baugruppe hin an den Baugruppenträger Steckanschlüsse angeordnet sind, und mit einem Masseanschlußteil; (siche z.B. DE-U-8 903 468).

Bei einer bekannten Baugruppe der obengenannten Art (DE-U-84 15 458) erfolgt die Fertigung und Montage der Komponenten noch recht aufwendig in mehreren, manuell zu verrichtenden Arbeitsschritten. Besondere Aufmerksamkeit erfordert die Kontaktierung der Steckanschlüsse der Baugruppe mit am Baugruppenträger vorhandenen Gegensteckanschlüssen, damit die Anschlüsse bei häufigem Aufschwenken der Baugruppe auf den Baugruppenträger nicht beschädigt werden. Hierzu wird auf eine vom Anmelder eingereichte europäische Patentanmeldung verwiesen, die eine aus einzelnen Baugruppen zusammengesetzte, elektrische Anlage betrifft. In dieser Anmeldung wird aufgezeigt, durch welche baulichen Maßnahmen des Baugruppenträgers die für die Kontaktierung erforderliche Lagegenauigkeit der Gegensteckanschlüsse zu den Steckanschlüssen zu verbessern ist.

Der vorliegenden Erfindung liegt die Aufgabe zugrunde, die Komponenten der Baugruppe so zu gestalten, daß eine automatengerechte Montage der Baugruppe in einfachen, geradlinigen Abläufen möglich ist.

Diese Aufgabe wird bei einer Baugruppe der obengenannten Art dadurch gelöst,
a) daß die Gehäuseschale Mittel zur Positionierung des Masseanschlußteils aufweist,
b) daß weitere Mittel zur Befestigung des Masseanschlußteils an der Gehäuseschale vorgesehen sind,
c) daß die Steckanschlüsse auf der Leiterplatte in einer bestimmten Lage zu deren Ausbildungen angebracht sind,
d) und daß in bestimmtem Abstand zu den Steckanschlüssen im zusammengesetzten Zustand der Baugruppe ein zu der Gehäuseschale gehöriges Lagerelement für die Baugruppe vorgesehen ist, welches einem Gegenstück an einem Kunststoffträger, der Teil des Baugruppenträgers ist, angepaßt ist.

Weist die Gehäuseschale an den sich rechtwinklig zur Anschlußseite der Baugruppe anschließenden Schmalseiten Lüftungsgitter auf, so kann über diese die beim Betrieb der Leiterplatte erzeugte Verlustwärme abgeführt werden. Es ist von Vorteil, wenn die ersten, zweiten und dritten Mittel sowie gegebenenfalls das Lagerelement an der Gehäuseschale oder an dem Abdeckteil angeformt sind, da sich diese Teile als Formteile einfach und kostengünstig fertigen lassen. Eine ansonsten erforderliche, zeitaufwendige Befestigung der genannten Mittel entfällt. Eine besonders einfache Ausgestaltung ist dadurch gegeben, wenn die ersten Mittel zur Positionierung der Leiterplatte als Leiterplatten-Zentrierbolzen ausgeführt sind, und wenn die entsprechenden Ausbildungen der Leiterplatte Löcher sind. Bei der Fertigung einer Baugruppe mittels Automaten wird die Leiterplatte in vorpositionierter Lage auf die Gehäuseschale mit den Leiterplatten-Zentrierbolzen abgesenkt, die die Leiterplatte über ihre Löcher genau positioniert. Sind die zweiten Mittel zur Positionierung des Masseanschlußteils als an der Innenwand der Gehäuseschale senkrecht von der Innenwand wegweisende Zentrierbolzen ausgeführt, und ist in der Gehäuseschale eine der Form des Masseanschlußteils angepaßte Ausnehmung vorgesehen, so läßt sich hiermit das Masseanschlußteil durch Positionierung mit den Zentrierbolzen und anschließendes Einsenken in die Ausnehmung in eine vorbestimmte, seitlich nicht verschiebbare Lage bringen. Eine einfache Ausführung besteht darin, daß die Leiterplatten-Zentrierbolzen zugleich als Zentrierbolzen zur Zentrierung des Masseanschlußteils dienen. Ein versehentliches Abziehen des Masseanschlußteils entgegen seiner Aufsteckrichtung kann dadurch vermieden werden, daß dritte Mittel zur Befestigung des Masseanschlußteils als ein an diesem vorgesehener Vorsprung in eine entsprechend ausgebildete Vertiefung an der Gehäuseschale einrastbar sind. Um die Baugruppe z.B. durch Aufschwenken auf den Baugruppenträger mit diesem mechanisch und über die Steckanschlüsse elektrisch in Verbindung zu bringen, ist es vorteilhaft, wenn das Lagerelement als tropfenförmige Absätze ausgebildet ist. Über dieses Lagerelement werden beim Einschwenken der Baugruppe ihre Steckanschlüsse in eine den Gegensteckanschlüssen des Baugruppenträgers gegenüberliegende Position gebracht, was ihre Kontaktierung erleichtert. Eine zusätzliche Hilfsmaßnahme zur besseren Kontaktierung der Steckanschlüsse mit den Gegensteckanschlüssen ist gegeben, wenn außer den tropfenförmigen Absätzen die Gehäuseschale einen Steg auf der Anschlußseite der Baugruppe aufweist, der in einem definierten Abstand zu den Steckanschlüssen der Baugruppe vorgesehen ist. Dieser Steg erlaubt eine genauere Positionierung der Baugruppe, wenn an dem Einbauplatz der Baugruppe am Baugruppenträger in entsprechendem Abstand von den dortigen Gegensteckanschlüssen ein vorstehendes Federelement vorgesehen ist, an dem sich der Steg beim Einschwenken der Baugruppe abstützt. Um störende Einflüsse durch äußere elektromagnetische Felder auf den Betrieb der Baugruppe zu vermeiden, ist es zweckmäßig, daß die Leiterplatte in der Baugruppe von einem Metallblech umgeben ist, das wie die Masse der Leiterplatte mit dem Masseanschlußteil elektrisch verbunden ist. Sind an der Innenwand der Gehäuseschale verpreßbare Zentrierzapfen vorgesehen, über die ein erstes Schirmblech mit entsprechenden Bohrlöchern positionierbar ist, so ist hierdurch das Aufbringen des Schirmblechs auf die Gehäuseschale auch mittels Automaten möglich. Das Schirmblech kann nach Positionierung durch die anschließende Verpressung der Zentrierbolzen befestigt werden. Zur vollständigen Schirmung der Leiterplatte ist es vorteilhaft, daß ein zweites Schirmblech im fertig montierten Zustand der Baugruppe auf der dem ersten Schirmblech abgewandten Seite der Leiterplatte vorgesehen ist, wobei die beiden Schirmbleche auf der der Anschlußseite gegenüberliegen den Seite abgewinkelt sind und die abgewinkelten Schirmblechflächen sich zumindest teilweise überlappen. Durch die Aufteilung des elektromagnetischen Schirms in zwei Teile, die sich im zusammenmontierten Zustand der Baugruppe mit ihren abgewinkelten Schirmblechflächen überlappen, wird eine einfache Fertigung und Montage des Schirms erreicht. Für den Fall, daß eine Leiterplatte zu schirmen ist, die frontseitig Stecker aufweist, erweist es sich hinsichtlich einer guten Schirmwirkung als günstig, wenn das zweite Schirmblech an der Leiterplatte befestigt ist und in seiner abgewinkelten Schirmblechfläche Ausbrüche und zwei Löcher hat, wobei die Ausbrüche in ihren Abmessungen den Metallkragen von frontseitig an der Leiterplatte angeordneten und an dieser angelöteten Steckern entsprechen und das Schirmblech über die Löcher mit dem Metallkragen verschraubbar ist. Auf diese Weise wird eine voll wirksame Schirmung unter Einschluß von Steckern an der Leiterplatte erreicht. Damit das Masseanschlußteil positioniert werden kann und eine besonders gute galvanische Verbindung zu den Schirmblechen hergestellt werden kann, ist es vorteilhaft, wenn das Masseanschlußteil als gekröpfter Erdungsbügel ausgeführt ist, welcher ein zum Zentrierbolzen passendes Positionierloch, ein Befestigungsloch sowie Gewindelöcher aufweist, über die die Schirmbleche anschraubbar sind. Durch die Kröpfung des Erdungsbügels und die Gewindelöcher wird einerseits der Abstand beider Schirmbleche voneinander überbrückt und außerdem lassen sich die Schirmbleche mit dem Erdungsbügel verschrauben. Zur genauen Positionierung der Steckanschlüsse gehört ihr definierter Abstand von der Aussenfläche der Gehäuseschale, an die sie über die Leiterplatte montiert sind. Dabei sollten die Steckanschlüsse möglichst von der Außenfläche der Baugruppe stets in gleichem Abstand, unabhängig von der Dicke der Leiterplatte angeordnet werden, um den Einfluß von unvermeidbaren Dickentoleranzen der Leiterplatten auszuschalten. Diese Aufgabe läßt sich in vorteilhafter Weise dadurch lösen, wenn die Gehäuseschale auf der zum Innenraum der Baugruppe liegenden Seite Auflagepunkte aufweist, auf die die Leiterplatte mit einer ihrer beiden Flächen zur Montage auflegbar ist, wenn die Auflagepunkte zu der Außenfläche der Gehäuseschale einen definierten Abstand aufweisen, und wenn die Steckanschlüsse in definiertem Abstand zu der aufzulegenden Fläche an derselben befestigt sind. Außerdem sollten die Baugruppen unabhängig von der Dickentoleranz der Leiterplatten stets gleich breit sein. Dies wird erreicht, wenn die Gehäuseschale und das Abdeckteil Flächen aufweisen, die von der Außenfläche der Gehäuseschale einen definierten Abstand haben, und wenn jeweils eine Fläche der Gehäuseschale in montiertem Zustand der Baugruppe auf einer entsprechenden gegenüberliegenden Fläche des Abdeckteils aufliegt. In einigen Anwendungsfällen ist die Verwendung von Baugruppen mit zwei Leiterplatten zweckmäßig, weil z.B. eine Schaltung hinsichtlich des Platzbedarfs nicht auf einer einzigen Leiterplatte realisierbar ist. Für diese Fälle ist es günstig, wenn die Gehäuseschale in zu ihrer Außenwand parallelen, definiert beabstandeten Ebenen Leiterplatten-Zentrierbolzen und Flächen aufweist, über die neben der ersten Leiterplatte eine weitere Leiterplatte mit an entsprechenden Stellen versehenen Löchern positionierbar und anschraubbar ist, wobei über einige Flächen das Abdeckteil an die Gehäuseschale direkt anschraubbar ist. Diese Ausführungsform zeichnet sich zudem durch automatengerechte Montage einer Baugruppe mit zwei Leiterplatten aus. Ist die Baugruppe auf der zu ihrer Anschlußseite gegenüberliegenden Seite hin offen, so können auch Leiterplatten verwendet werden, die durch die Öffnung hindurchragen. Um Beschädigungen der Leiterplatte und anderer Bauteile der Baugruppe über die Öffnung zu vermeiden, ist es vorteilhaft, wenn auf der der Anschlußseite der Baugruppe gegenüberliegenden, offenen Seite eine Fronthaube aufsteckbar ist. Weist die Fronthaube an ihren Längskanten nach außen hin abgeflachte Zähne auf, die mit den Wänden von Gehäuseschale und Abdeckteil in Eingriff bringbar sind, so kann hierdurch das Aufstecken der Fronthaube, was oftmals wegen der eingezogenen Wände Schwierigkeiten bereitet, erleichtert werden. Eine zusätzliche Verbesserung besteht darin, daß die Länge der Zähne von den Schmalseiten der Fronthaube hin zur Mitte der Längskanten abnimmt. Ist die Fronthaube abgestuft, und weist der zurückliegende Frontteil einen Ausschnitt auf, über den wenigstens ein an der Leiterplatte angelöteter Stecker kontaktierbar ist, so ist über diesen Stecker eine externe elektrische Verbindung zur Übermittlung von Eingangs- und Ausgangssignalen möglich. Eine günstige Ausgestaltung ergibt sich dadurch, daß eine Abdeckhaube mit dem abgestuften Raum angepaßten Abmessungen vorgesehen ist, damit dieser abgestufte Teil mit dem Ausschnitt im Bedarfsfall abgedeckt werden kann. Weisen die Gehäuseschale und das Abdeckteil zur Anschlußseite der Baugruppe hin für dieselbe eine Schürze bildende, vorspringende Flächen auf, so wird mit der Schürze einerseits vermieden, daß die Steckanschlüsse vorstehen und somit leicht beschädigt werden können. Zum anderen wird die Baugruppe durch die Schürze beim Aufschwenken auf den Baugruppenträger geführt, wenn die Schürze an entsprechend angeordneten Flächen am Baugruppeneinbauplatz des Baugruppenträgers entlanggleiten kann. Der versehentliche Anschluß einer nicht zu einem Einbauplatz am Baugruppenträger passenden Baugruppe läßt sich vermeiden, wenn an der Anschlußseite die Baugruppe ein Codierelement aufweist, zu welchem am Baugruppenträger an entsprechender Stelle ein angepaßtes Gegenelement vorgesehen ist.

In der Zeichnung ist ein Ausführungsbeispiel der Erfindung dargestellt, das im folgenden näher beschrieben ist.

Es zeigen:
- FIG 1: eine an einem Baugruppenträger befestigte Baugruppe,
- FIG 2: die Innenansicht einer Gehäuseschale mit Erdungsbügel und Schraubbolzen,
- FIG 3: Teile der Baugruppe nach FIG 1 in Explosionsdarstellung,
- FIG 4: einen Erdungsbügel,
- FIG 5: eine Gehäuseschale mit einer daran verschraubten Leiterplatte,
- FIG 6: eine Baugruppe mit einer Leiterplatte im Querschnitt,
- FIG 7: eine Baugruppe mit zwei Leiterplatten im Querschnitt.
- FIG 8: eine doppelt breite Baugruppe mit Ausschnitt an ihrer Fronthaube.
- FIG 9: eine Teilansicht IX aus FIG 2.

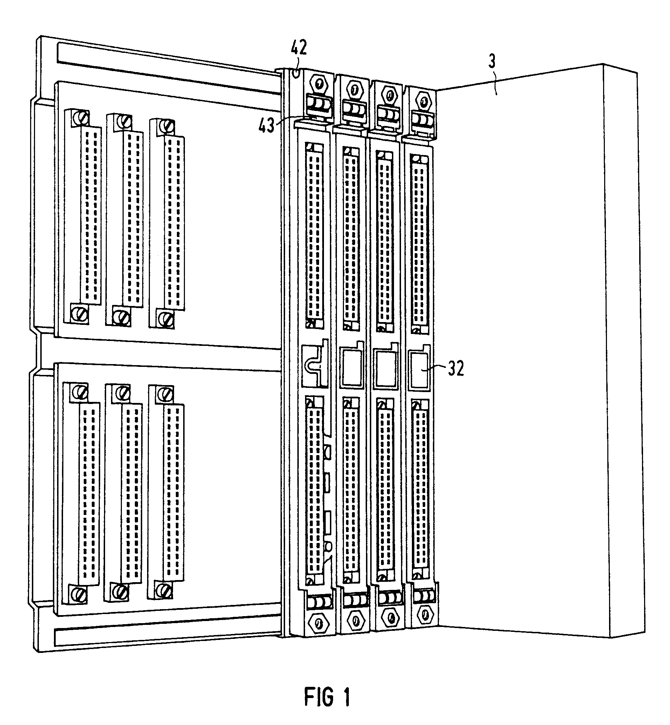

In FIG 1 ist eine an einem Baugruppenträger angeschlossene Baugruppe 3 dargestellt, wobei die zum Signalaustausch mit der Baugruppe 3 erforderliche elektrische Verbindung über die Gegensteckanschlüsse des Baugruppenträgers erfolgt, die hier in Form von Federleisten ausgeführt sind. Über eine Aufschwenkvertiefung 42 an der Oberseite des Baugruppenträgers ist die Baugruppe 3 aufschwenkbar, wobei ihre Höhenpositionierung über ein Federelement 43 erfolgt.

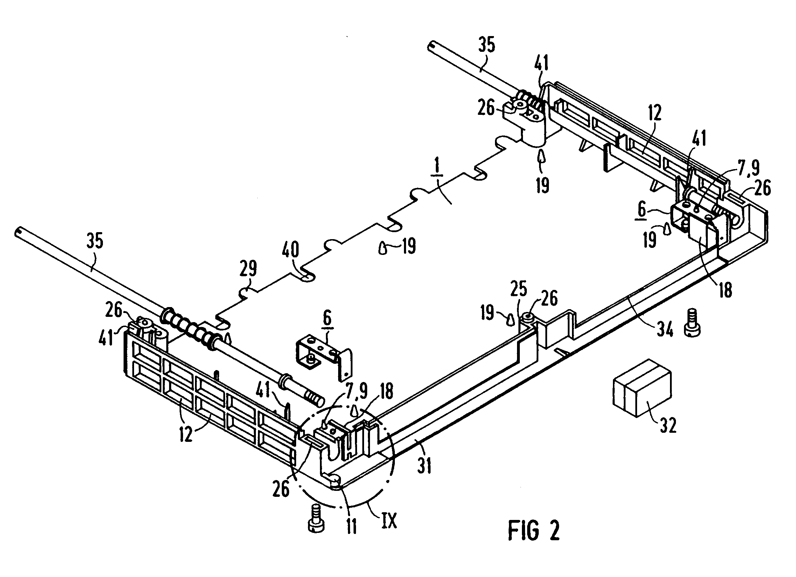

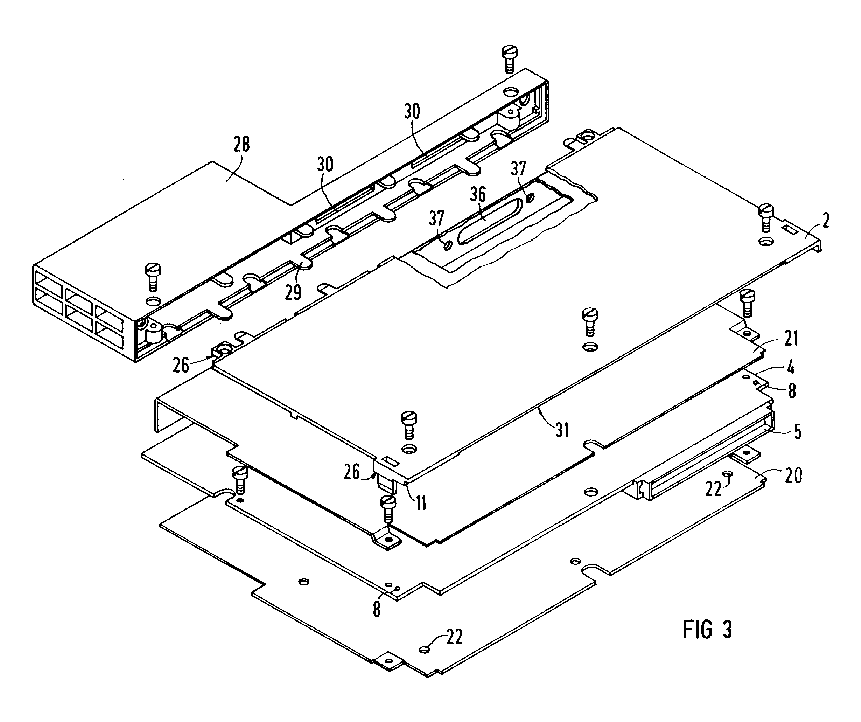

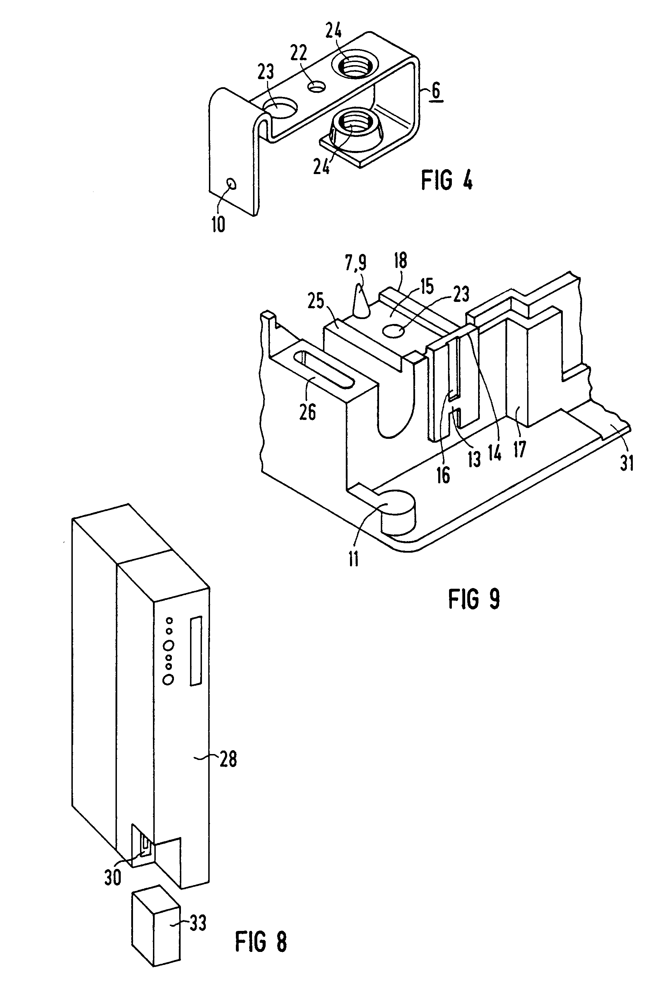

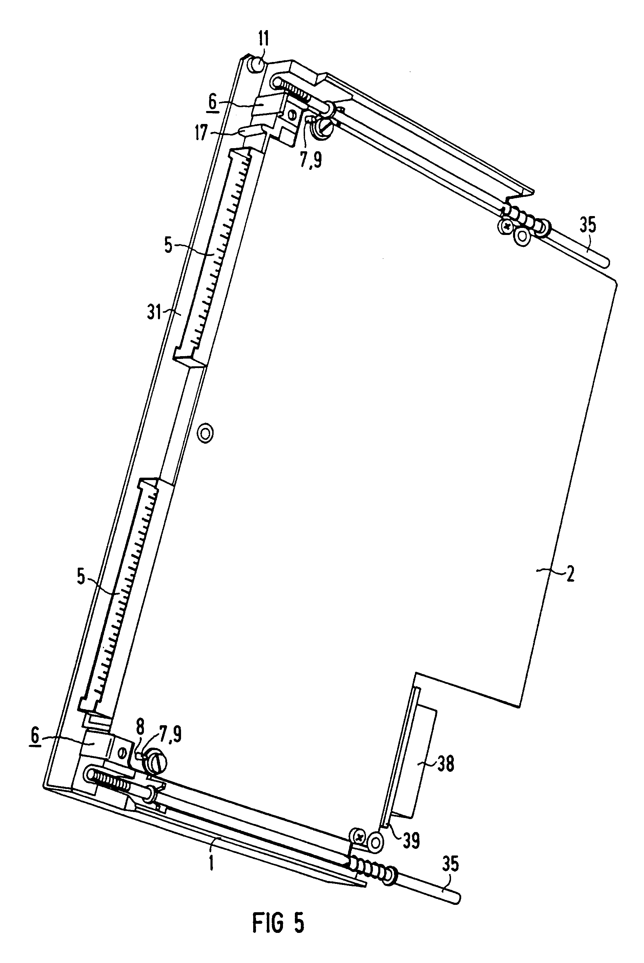

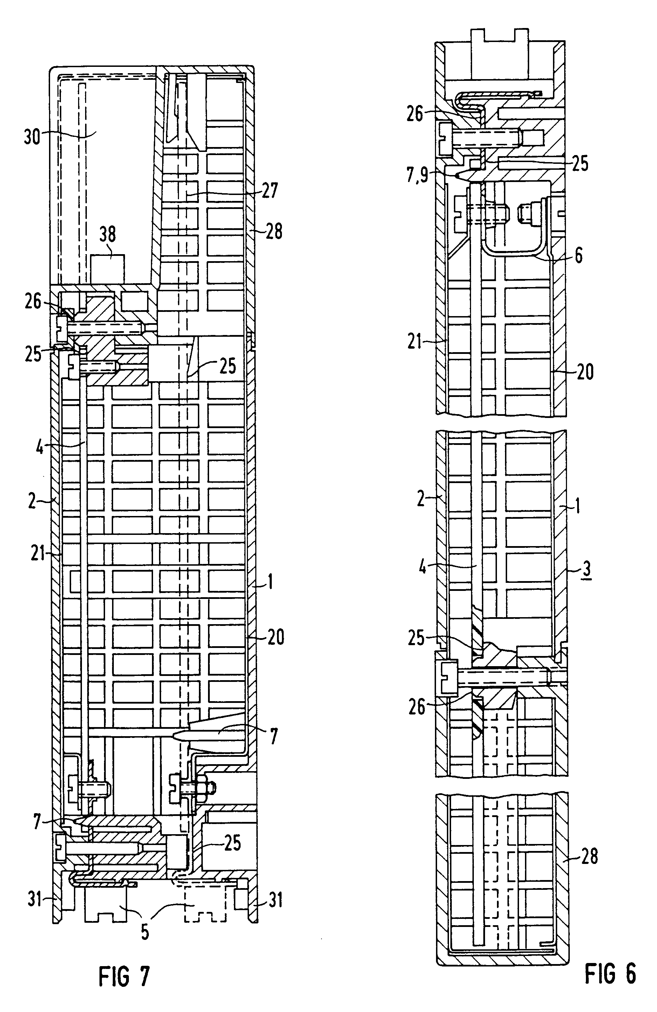

Die Baugruppe 3 ist aus einer Gehäuseschale 1 (siehe FIG 2) und aus einem Abdeckteil 2 (siehe FIG 3, 6) zusammengesetzt. FIG 2 zeigt die Innenseite einer Gehäuseschale 1, die an ihren Schmalseiten Lüftungsgitter 12 aufweist. Über diese Lüftungsgitter 12 wird im eingebauten Zustand der Baugruppe 3 die beim Betrieb der Baugruppe 3 erzeugte Verlustwärme abgeführt. An der Innenwand der Gehäuseschale 1 sind Zentrierzapfen 19 vorgesehen, über die z.B. ein erstes Schirmblech 20 (siehe FIG 3), das entsprechende Positionierlöcher 22 aufweist, mittels eines Automaten positioniert und anschließend durch Verpressung der Zentrierzapfen 19 befestigt werden kann. An der für den späteren Anschluß der Baugruppe 3 bestimmten Längsseite sind in dichtem Abstand zwei Blöcke 18 z.B. aus Kunststoff angeformt, die sowohl zur Befestigung von Erdungsbügeln 6 und einer Leiterplatte 4 (siehe FIG 3) dienen. Die beiden Blöcke 18 weisen einen stegartigen Vorsprung 14, über den der Erdungsbügel 6 übergeschoben wird, und eine nutförmige Ausnehmung 15 parallel zu den Schmalseiten der Gehäuseschale 1 auf, wobei in der Nut 15 jeweils ein Verschraubungsloch 23 ist und daneben liegend zu diesem aus der Ausnehmung 15 jeweils ein Leiterplatten-Zentrierbolzen 7 vorsteht. An den genannten Blöcken 18 ist zur Anschlußseite hin eine schmale, nutförmige Vertiefung 16 vorgesehen, die parallel zu den kurzen Kanten der Schmalseiten mit den Lüftungsgittern 12 verläuft und die durch einen kleinen Quersteg 13 unterbrochen ist. Gegenüber den Blöcken 18 ragt zur Anschlußseite hin eine Fläche 31 vor, die zusammen mit einer entsprechenden Fläche 31 an dem Abdeckteil 2 (siehe FIG 3) eine Schürze der Baugruppe 3 bildet. Die Ausgestaltung in Form einer Schürze dient einerseits dem Zweck, Steckanschlüsse 5 an der Anschlußseite der Baugruppe 3 vor Beschädigungen zu schützen und andererseits in Verbindung mit einem am Baugruppenträger für jeden Einbauplatz entsprechend gestalteten Absatz das Einschwenken der Baugruppe 3 auf den Baugruppenträger zu erleichtern. Über die Schürze wird die Baugruppe 3 beim Einschwenken seitlich geführt. Zum Einschwenken der Baugruppe 3 ist außerdem an den vorspringenden Flächen 31 der Gehäuseschale 1 und des Abdeckteils 2 jeweils ein tropfenförmiger Absatz 11 vorgesehen. In den diesen Absätzen 11 in Form angepaßten Aufschwenkvertiefungen 42 an der Oberseite des Baugruppenträgers (siehe FIG 1) wird die Baugruppe 3 beim Aufschwenken auf den Baugruppenträger über ihre Absätze 11 eingeführt und gelagert. Zur Anschlußseite hin weist die Gehäuseschale 1 eine Aussparung 34 auf, durch die die Steckanschlüsse 5 der Baugruppe 3 hindurchragen können. In FIG 2 ist zwar nur eine Aussparung dargestellt, doch ist es auch möglich, im Bedarfsfall eine zweite Aussparung für weitere Steckanschlüsse 5 in der anderen Hälfte der Gehäuseschale 1 vorzusehen. Weiterhin ist an der Anschlußseite ein Steg 17 (siehe FIG 5) in bestimmtem Abstand zu dem Leiterplatten-Zentrierbolzen 7 vorgesehen. An der der Anschlußseite gegenüberliegenden schmalen Längskante der Gehäuseschale 1 sind Zähne 29 (siehe FIG 2) angeformt, die nach außen hin abgeflacht sind. Die Innenwand an dieser Längsseite weist zahnförmige, abgeschrägte Vertiefungen 40 auf. FIG 4 zeigt einen gekröpften Erdungsbügel 6 mit einem Positionierloch 22, einem Befestigungsloch 23, sowie zwei Gewindelöchern 24. Der Erdungsbügel 6 ist derart geformt, daß er mittels eines Automaten über sein Positionierloch 22 auf den vorbeschriebenen Block 18 aufsteckbar ist, wobei der Leiterplatten-Zentrierbolzen 7 zur Führung in das Positionierloch 22 eingreift und ein Vorsprung 10 an der Innenseite des Erdungsbügels 6 außerdem als Führungsmittel in der nutförmigen Vertiefung 16 dient, an deren Quersteg 13 eine Verrastung erfolgt. Nach Aufstecken des Erdungsbügels 6 ist er in der nutförmigen Ausnehmung 15 versenkt, so daß hierdurch sein seitliches Verschieben bei der Montage verhindert wird. Nachdem beide Erdungsbügel 6 in genannter Weise auf die Gehäuseschale 1 aufgesteckt sind, können zur Befestigung der Baugruppe 3 dienende Schraubbolzen 35 in entsprechende Schlitze 41 durch Automaten eingerastet werden sowie die Leiterplatte 4 (siehe FIG 3) mit den an ihr bereits vormontierten Steckanschlüssen 5 und gegebenenfalls mit einem zweiten Schirmblech 21 auf die Gehäuseschale 1 aufgelegt werden. Auch das Auflegen ist mittels eines Automaten möglich, wobei den Leiterplatten-Zentrierbolzen 7 angepaßte Löcher 8 in der Leiterplatte 4 zu ihrer Positionierung vorgesehen sind. Die Löcher 8 und die Steckanschlüsse 5 befinden sich in einem bestimmten Abstand zueinander, wodurch eine definierte Beabstandung der Steckanschlüsse 5 zu dem Steg 17 und den Absätzen 11 an der Baugruppe 3 erreicht wird. Durch diese maßgenaue Zuordnung, die in entsprechender Weise auch zwischen den Gegensteckanschlüssen und der Aufschwenkvertiefung 42 sowie dem Federelement 43 am Baugruppenträger besteht, wird schließlich ein genaues Auftreffen der Steckanschlüsse 5 auf die Gegensteckanschlüsse gewährleistet. Über eines der beiden Gewindelöcher 24 an dem Erdungsbügel 6 (siehe FIG 4) kann nach der Positionierung eine Verschraubung der Leiterplatte 4 und des daran befestigten zweiten Schirmblechs 21 mit dem Erdungsbügel 6 erfolgen. Die Bauteilseite der Leiterplatte 4 ist der Innenwand der Gehäuseschale 1 zugewandt, was insbesondere auch für die Steckanschlüsse 5 zutrifft, die in der entsprechend geformten Aussparung 34 der Gehäuseschale 1 versenkt sind. Dies ist wesentlich, um auch einen vorbestimmten, seitlichen Abstand der Steckanschlüsse 5 zu der Außenwand der Gehäuseschale 1 zu erreichen. Da nämlich die Leiterplatte 4 auf zu den Blöcken 18 zugehörigen Auflagepunkten 25 aufliegt, die ebenfalls definiert von der Außenwand der Gehäuseschale 1 beabstandet sind, ist auch durch Befestigung der Steckanschlüsse 5 auf der Bauteilseite der Leiterplatte 4 für einen definierten seitlichen Abstand der Steckanschlüsse 5 gesorgt. Diese Ausführung zeichnet sich dadurch aus, daß unvermeidbare Dickentoleranzen der Leiterplatte 4 für die genaue Positionierung der Steckanschlüsse 5 unbedeutend sind.

Aus FIG 3 ist die Leiterplatte 4 der Baugruppe 3 mit den Schirmblechen 20, 21 zu beiden Seiten sowie der zugehörigen Abdeckplatte 2 und der Fronthaube 28 in Explosionsdarstellung ersichtlich. Hier ist deutlich der sandwichartige Aufbau zu erkennen, der ein Aufeinanderschichten mittels eines Automaten zuläßt. Die Fronthaube 28 wird über Zähne 29 aufgesteckt.

In FIG 6 ist eine zusammengesetzte Baugruppe, bestehend aus der Gehäuseschale 1, dem Erdungsbügel 6, dem ersten Schirmblech 20 der Leiterplatte 4 mit daran angebrachtem zweiten Schirmblech 21 sowie dem Abdeckteil 2 und einer Fronthaube 28 dargestellt. Hieraus wird deutlich, daß die Gehäuseschale 1 und das Abdeckteil 2 Flächen 26 aufweisen, die in montiertem Zustand der Baugruppe 3 direkt aufeinanderliegen und durch ihren definierten Abstand zu den jeweiligen Außenwänden auch eine bestimmte Breite der Baugruppe 3 ergeben. Somit ergibt sich die Baugruppenbreite unabhängig von der Leiterplatte 4 und ihrer möglichen Dickentoleranzen. Für den Fall, daß die Gehäuseschale 1 und das Abdeckteil 2 zur Frontseite hin offen sind, kann die Baugruppe 3 mit einer durch die Öffnung hindurchragenden Leiterplatte 4 versehen werden. Hierdurch ist eine Anpassung an erforderliche Leiterplattengrößen möglich, die dem Umfang der zu realisierenden Schaltung entsprechend benötigt werden. Zur Abdeckung der Öffnung dient die Fronthaube 28, die ebenfalls den Abmessungen der Leiterplatte 4 angepaßt ausgeführt werden kann. Diese Fronthaube 28 kann abgestuft sein, wenn z.B. die Leiterplatte 4 an ihrer Frontseite einen Stecker 38 trägt, welcher über einen Metallkragen 39 mit dem Schirmblech 21 verschraubt ist und über den ein externer Signalaustausch erfolgen soll, wie es z.B. für eine Doppelbaugruppe mit zwei Leiterplatten 4, 27 in FIG 7 dargestellt ist. Zu diesem Zweck ist an der Fronthaube 28 im abgestuften Teil ein Ausschnitt 30 zum Anschluß an den Stecker 38 vorhanden. Auch die Fronthaube 28 (siehe FIG 3) hat an ihren Längskanten nach außen abgeflachte Zähne 29, wie sie in FIG 2 für die Gehäuseschale 1 dargestellt sind. Zur Befestigung der Fronthaube 28 greifen diese Zähne 29 in die entsprechenden abgeschrägten Vertiefungen 40 an der Innenwand der Gehäuseschale 1 ein. Hierdurch wird das Aufstecken der Fronthaube 28 erleichtert, das wegen der leichten Verformbarkeit dünnwandiger Außenwände oftmals Schwierigkeiten bereitet. Nach dem Anschluß des Gegensteckers und für den Fall, daß von außen keine Anschlüsse an den Stecker 38 geführt werden, kann der Ausschnitt 30 im abgestuften Teil der Fronthaube 28 durch eine zusätzliche Abdeckhaube 33 abgedeckt werden, wie in FIG 8 dargestellt. An der Anschlußseite der Baugruppe 3 (siehe FIG 2) wird ein Codierelement 32 angebracht, was nur den Anschluß dieser Baugruppe 3 an einen Einbauplatz des Baugruppenträgers zuläßt, der ein entsprechend angepaßtes Gegenelement aufweist. Hierdurch ist es möglich, zu verhindern, daß versehentlich Baugruppen 3 in falsche Einbauplätze des Baugruppenträgers aufgeschwenkt werden.

FIG 7 zeigt eine Baugruppe mit zwei Leiterplatten 4, 27 im Querschnitt, die prinzipiell vom Aufbau her in beschriebener Weise der mit einer Leiterplatte 4 gleicht, zum Einsatz kommt jedoch eine abgewandelte Form des Erdungsbügels 6. Durch definierte Beabstandung von Leiterplatten-Zentrierbolzen 7 und Flächen 26 zur Gehäuseschale 1 lassen sich die beiden Leiterplatten 4, 27 mit an entsprechenden Stellen versehenen Löchern 8 ebenfalls positionieren und anschrauben. Die genaue Positionierung der Steckanschlüsse 5 unter Vermeidung von Dickentoleranzen der Leiterplatten 4 wird hier in gleicher Weise erreicht wie bei der Baugruppe 3 mit nur einer Leiterplatte 4. Ebenfalls wird wiederum die Gehäuseschale 1 direkt mit dem Abdeckteil 2 über entsprechende, aufeinanderliegende Flächen 26 verschraubt.

## Patentansprüche

1. Kastenförmige Baugruppe (3) zum Anschluß an einen Baugruppenträger, aus zumindest einer Gehäuseschale (1) und einem Abdeckteil (2) bestehend, mit einer Leiterplatte (4), an der zur Anschlußseite der Baugruppe (3) hin an den Baugruppenträger Steckanschlüsse (5) angeordnet sind, und mit einem Masseanschlußteil (6), wobei die Gehäuseschale (1) erste Mittel (7) zur Positionierung der Leiterplatte (4) hat, die ihrerseits diesen Mitteln (7) entsprechende Ausbildungen (8) besitzt, so daß hiermit die auf die Gehäuseschale (1) auflegbare Leiterplatte (4) zu dieser positionierbar ist, **dadurch gekennzeichnet,**
a) daß die Gehäuseschale (1) zweite Mittel (9) zur Positionierung des Masseanschlußteils (6) aufweist,
b) daß dritte Mittel (10) zur Befestigung des Masseanschlußteils (6) an der Gehäuseschale (1) vorgesehen sind,
c) daß die Steckanschlüsse (5) auf der Leiterplatte (4) in einer bestimmten Lage zu deren Ausbildungen (8) angebracht sind,
d) und daß in bestimmtem Abstand zu den Steckanschlüssen (5) im zusammengesetzten Zustand der Baugruppe (3) ein zu der Gehäuseschale (1) gehöriges Lagerelement (11) für die Baugruppe (3) vorgesehen ist, welches einem Gegenstück an einem Kunststoffträger, der Teil des Baugruppenträgers ist, angepaßt ist.

2. Baugruppe nach Anspruch 1, **dadurch gekennzeichnet,** daß die Gehäuseschale (1) an den sich rechtwinklig zur Anschlußseite der Baugruppe (3) anschließenden Schmalseiten Lüftungsgitter (12) aufweist.

3. Baugruppe nach Anspruch 1 oder 2, **dadurch gekennzeichnet,** daß die Mittel (7, 9) sowie gegebenenfalls das Lagerelement (11) an der Gehäuseschale (1) oder an dem Abdeckteil (2) angeformt sind.

4. Baugruppe nach einem der vorangehenden Ansprüche, **dadurch gekennzeichnet,** daß die ersten Mittel zur Positionierung der Leiterplatte (4) als Leiterplatten-Zentrierbolzen (7) ausgeführt sind, und daß die entsprechenden Ausbildungen der Leiterplatte (4) Löcher (8) sind.

5. Baugruppe nach einem der vorhergehenden Ansprüche, **dadurch gekennzeichnet,** daß die zweiten Mittel zur Positionierung des Masseanschlußteils (4) als an der Innenwand der Gehäuseschale (1) senkrecht von der Innenwand wegweisende Zentrierbolzen (9) ausgeführt sind, und daß in der Gehäuseschale (1) eine der Form des Masseanschlußteils (6) angepaßte Ausnehmung (15) vorgesehen ist.

6. Baugruppe nach Anspruch 4 oder 5, **dadurch gekennzeichnet,** daß die Leiterplatten-Zentrierbolzen (7) zugleich als Zentrierbolzen (9) zur Zentrierung des Masseanschlußteils (6) dienen.

7. Baugruppe nach einem der vorhergehenden Ansprüche, **dadurch gekennzeichnet,** daß dritte Mittel zur Befestigung des Masseanschlußteils (6) als ein an diesem vorgesehener Vorsprung (10) in eine entsprechend ausgebildete Vertiefung (16) an der Gehäuseschale (1) einrastbar sind.

8. Baugruppe nach einem der vorangehenden Ansprüche, **dadurch gekennzeichnet,** daß das Lagerelement als tropfenförmige Absätze (11) ausgebildet ist.

9. Baugruppe nach einem der vorangehenden Ansprüche, **dadurch gekennzeichnet,** daß außer den Absätzen (11) die Gehäuseschale einen Steg (17) auf der Anschlußseite der Baugruppe (3) aufweist, der in einem definierten Abstand zu den Steckanschlüssen (5) der Baugruppe (3) vorgesehen ist.

10. Baugruppe nach einem der vorangehenden Ansprüche, **dadurch gekennzeichnet,** daß die Leiterplatte (4) in der Baugruppe (3) von einem Metallblech (20, 21) umgeben ist, das wie die Masse der Leiterplatte (4) mit dem Masseanschlußteil (6) elektrisch verbunden ist.

11. Baugruppe nach einem der vorangehenden Ansprüche, **dadurch gekennzeichnet,** daß an der Innenwand der Gehäuseschale (1) verpreßbare Zentrierzapfen (19) vorgesehen sind, über die ein erstes Schirmblech (20) mit entsprechenden Bohrlöchern positionierbar ist.

12. Baugruppe nach Anspruch 11, **dadurch gekennzeichnet,** daß ein zweites Schirmblech (21) im fertig montierten Zustand der Baugruppe (3) auf der dem ersten Schirmblech (20) abgewandten Seite der Leiterplatte (4) vorgesehen ist, wobei die Schirmbleche (20, 21) auf der der Anschlußseite gegenüberliegenden Seite abgewinkelt sind und die abgewinkelten Schirmblechflächen sich zumindest teilweise überlappen.

13. Baugruppe nach Anspruch 12, **dadurch gekennzeichnet,** daß das zweite Schirmblech (21) an der Leiterplatte (4) befestigt ist und in seiner abgewinkelten Schirmblechfläche Ausbrüche (36) und Löcher (37) hat, wobei die Ausbrüche in ihren Abmessungen den Metallkragen (39) von frontseitig an der Leiterplatte (4) angeordneten und an dieser angelöteten Steckern (38) entsprechen und das Schirmblech (21) über die Löcher mit dem Metallkragen (39) verschraubbar ist.

14. Baugruppe nach einem der vorangehenden Ansprüche, **dadurch gekennzeichnet,** daß das Masseanschlußteil als gekröpfter Erdungsbügel (6) ausgeführt ist, welcher ein zum Zentrierbolzen (9) passendes Positionierloch (22), ein Befestigungsloch (23) sowie Gewindelöcher (24) aufweist, über die die Schirmbleche (20, 21) anschraubbar sind.

15. Baugruppe nach einem der vorangehenden Ansprüche, **dadurch gekennzeichnet,** daß die Gehäuseschale (1) auf der zum Innenraum der Baugruppe (3) liegenden Seite Auflagepunkte (25) aufweist, auf die die Leiterplatte (4) mit einer ihrer beiden Flächen zur Montage auflegbar ist, daß die Auflagepunkte (25) zu der Außenfläche der Gehäuseschale (1) einen definierten Abstand aufweisen, und daß die Steckanschlüsse (5) in definiertem Abstand zu der aufzulegenden Fläche an derselben befestigt sind.

16. Baugruppe nach einem der vorangehenden Ansprüche, **dadurch gekennzeichnet,** daß die Gehäuseschale (1) und das Abdeckteil (2) Flächen (26) aufweisen, die von der Außenfläche der Gehäuseschale (1) einen definierten Abstand haben, und daß jeweils eine Fläche (26) der Gehäuseschale (1) in montiertem Zustand der Baugruppe (3) auf einer entsprechenden gegenüberliegenden Fläche (26) des Abdeckteils (2) aufliegt.

17. Baugruppe nach einem der vorangehenden Ansprüche, **dadurch gekennzeichnet,** daß die Gehäuseschale (1) in zu ihrer Außenwand parallelen, definiert beabstandeten Ebenen Leiterplatten-Zentrierbolzen (7) und Flächen (26) aufweist, über die neben der Leiterplatte (4) eine weitere Leiterplatte (27) mit an entsprechenden Stellen versehenen Löchern positionierbar und anschraubbar ist, wobei über einige Flächen (26) das Abdeckteil (2) an die Gehäuseschale (1) direkt anschraubbar ist.

18. Baugruppe nach einem der vorangehenden Ansprüche, **dadurch gekennzeichnet,** daß die Baugruppe (3) auf der zu ihrer Anschlußseite gegenüberliegenden Seite offen ist.

19. Baugruppe nach Anspruch 18, **dadurch gekennzeichnet,** daß auf der der Anschlußseite der Baugruppe (3) gegenüberliegenden, offenen Seite eine Fronthaube (28) aufsteckbar ist.

20. Baugruppe nach Anspruch 19, **dadurch gekennzeichnet,** daß die Fronthaube (28) an ihren Längskanten nach außen hin abgeflachte Zähne (29) aufweist, die mit den Wänden von Gehäuseschale (1) und Abdeckteil (2) in Eingriff bringbar sind.

21. Baugruppe nach Anspruch 20, **dadurch gekennzeichnet,** daß die Länge der Zähne (29) von den Schmalseiten der Fronthaube (28) hin zur Mitte der Längskanten abnimmt.

22. Baugruppe nach Anspruch 21, **dadurch gekennzeichnet,** daß die Fronthaube (28) abgestuft ist und der zurückliegende Frontteil wenigstens einen Ausschnitt (30) aufweist, über den wenigstens ein an der Leiterplatte (4) angelöteter Stecker (38) kontaktierbar ist.

23. Baugruppen nach Anspruch 22, **dadurch gekennzeichnet,** daß eine Abdeckhaube (33) mit dem abgestuften Raum angepaßten Abmessungen vorgesehen ist.

24. Baugruppe nach einem der vorangehenden Ansprüche, **dadurch gekennzeichnet,** daß die Gehäuseschale (1) und das Abdeckteil (2) zur Anschlußseite der Baugruppe (3) hin für dieselbe eine Schürze bildende, vorspringende Flächen (31) aufweisen.

25. Baugruppe nach einem der vorangehenden Ansprüche, **dadurch gekennzeichnet,** daß an der Anschlußseite die Baugruppe (3) ein Codierelement (32) aufweist, zu welchem am Baugruppenträger an entsprechender Stelle ein angepaßtes Gegenelement vorgesehen ist.

26. Baugruppe nach einem der vorangegangenen Ansprüche, **dadurch gekennzeichnet,** daß diese wenigstens einen Schraubbolzen (35) zu ihrer Befestigung am Baugruppenträger aufweist.

## Claims

1. Box-shaped module (3) for connection to a mounting rack, comprising at least a housing shell (1) and a cover (2), having a printed circuit-board (4) on which plug-and-socket connections (5) to the mounting rack are arranged towards the connection side of the module (3) and having an earth terminal (6), wherein the housing shell (1) has first means (7) for positioning the printed circuit-board (4) which, in turn, has formations (8) corresponding to these means (7), so that the printed circuit-board (4) which can be placed on the housing shell (1) can thus be positioned relative thereto, characterised in that
(a) the housing shell (1) has second means (9) for positioning the earth terminal (6),
(b) in that third means (10) are provided for securing the earth terminal (6) to the housing shell (1),
(c) in that the plug-and-socket connections (5) on the printed circuit-board (4) are attached in a pre-determined position relative to the formations (8) thereof,
(d) and in that, at a pre-determined distance from the plug-and-socket connections (5), in the assembled state of the module (3), a bearing element (11) associated with the housing shell (1) is provided for the module (3), which bearing element matches a counterpart on a plastics support forming part of the mounting rack.

2. Module according to claim 1, characterised in that the housing shell (1) has ventilation grids (12) on the narrow sides adjacent at right angles to the connection side of the module (3).

3. Module according to claim 1 or 2, characterised in that the means (7, 9) as well as the bearing element (11), if necessary, are pre-formed on the housing shell (1) or on the cover (2).

4. Module according to one of the preceding claims, characterised in that the first means for positioning the printed circuit-board (4) are constructed as printed circuit-board centring pins (7), and in that the corresponding formations of the printed circuit-board (4) are holes (8).

5. Module according to one of the preceding claims, characterised in that the second means for positioning the earth terminal (4) (sic) are constructed as centring pins (9) on the inner wall of the housing shell (1), pointing perpendicularly away from the inner wall, and in that a recess (15) matching the shape of the earth terminal (6) is provided in the housing shell (1).

6. Module according to claim 4 or 5, characterised in that the printed circuit-board centring pins (7) serve at the same time as centring pins (9) for centring the earth terminal (6).

7. Module according to one of the preceding claims, characterised in that third means for securing the earth terminal (6), which means are provided thereon as a projection (10), can engage in a correspondingly formed depression (16) on the housing shell (1).

8. Module according to one of the preceding claims, characterised in that the bearing element is formed as drop-shaped offsets (11).

9. Module according to one of the preceding claims, characterised in that, in addition to the offsets, the housing shell has a web (17) on the connection side of the module (3), which web is provided at a pre-determined distance from the plug-and-socket connections (5) of the module (3).

10. Module according to one of the preceding claims, characterised in that the printed circuit-board (4) is surrounded within the module (3) by a metal sheet (20, 21) which, like the earth of the printed circuit-board (4), is electrically connected to the earth terminal (6).

11. Module according to one of the preceding claims, characterised in that pressable centring pins (19) are provided on the inner wall of the housing shell (1), wherein a first shield (20) having corresponding holes can be positioned by way of these centring pins (19).

12. Module according to claim 11, characterised in that, in the ready assembled state of the module (3), a second shield (21) is provided on the side of the printed circuit-board (4) facing away from the first shield (20), wherein the shields (20, 21) are bent down on the side opposite the connection side and the bent-down shield surfaces overlap at least partially.

13. Module according to claim 12, characterised in that the second shield (21) is secured to the printed circuit-board (4) and has cut-outs (36) and holes (37) in its bent-down shield surface, wherein the dimensions of the cut-outs correspond to the metal collars (39) of plug connectors (38) arranged on the front side of the printed circuit-board (4) and soldered on to the said printed circuit-board, and the shield (21) can be screwed on to the metal collar (39) by way of the holes.

14. Module according to one of the preceding claims, characterised in that the earth terminal is constructed as an earthing clip (6) bent at right angles, which has a positioning hole (22) matching the centring pin (9), a fastening hole (23), and threaded holes (24) by way of which the shields (20, 21) can be screwed down.

15. Module according to one of the preceding claims, characterised in that the housing shell (1) has points of support (25) on the side located towards the interior space of the module (3), on which points of support one of the two surfaces of the printed circuit-board (4) can be placed for assembly, in that the points of support (25) are at a pre-determined distance from the outer surface of the housing shell (1), and in that the plug-and-socket connections (5) are secured to the surface to be placed in position at a pre-determined distance therefrom.

16. Module according to one of the preceding claims, characterised in that the housing shell (1) and the cover (2) have surfaces (26) which are at a pre-determined distance from the outer surface of the housing shell (1), and in that a respective surface (26) of the housing shell (1) is supported on a corresponding opposite surface (26) of the cover (2) in the assembled state of the module (3).

17. Module according to one of the preceding claims, characterised in that the housing shell (1) has printed circuit-board centring pins (7) in planes which are parallel with the outer wall of the said housing shell and are separated by a pre-determined distance, and surfaces (26), by way of which, in addition to the printed circuit-board (4), a further printed circuit-board (27) can be positioned and screwed down by means of holes provided at appropriate places, wherein the cover (2) can be screwed down directly on to the housing shell (1) by way of several surfaces (26).

18. Module according to one of the preceding claims, characterised in that the module (3) is open on the side opposite its connection side.

19. Module according to claim 18, characterised in that a front hood (28) can be attached to the open side opposite the connection side of the module (3).

20. Module according to claim 19, characterised in that the front hood (28) has on its longitudinal edges, teeth (29) flattened towards the outside, which teeth can be engaged with the walls of the housing shell (1) and cover (2).

21. Module according to claim 20, characterised in that the length of the teeth (29) decreases from the narrow sides of the front hood (28) towards the middle of the longitudinal edges.

22. Module according to claim 21, characterised in that the front hood (28) is stepped and the recessed front part has at least one cut-away portion (30) by way of which at least one plug connector (38) soldered on to the printed circuit-board (4) is capable of contact.

23. Modules according to claim 22, characterised in that a covering hood (33) is provided with dimensions which match the stepped space.

24. Module according to one of the preceding claims, characterised in that the housing shell (1) and the cover (2) have surfaces (31) projecting towards the connection side of the module (3) and forming a skirt for the said module.

25. Module according to one of the preceding claims, characterised in that the module (3) has a coding element (32) on the connection side, with a matched counterpart being provided at an appropriate place on the mounting rack.

26. Module according to one of the preceding claims, characterised in that the module (3) has at least one threaded bolt (35) for securing it to the mounting rack.

## Revendications

1. Module (3) en forme de boîte, destiné à être connnecté à un support de modules, constitué d'au moins une coque (1) formant enveloppe et d'une pièce de recouvrement (2), comportant une plaquette de circuits imprimés (4), sur laquelle coque sont disposés en direction du côté de branchement du module (3) des connecteurs à fiches (5) de connexion au support de modules, et une pièce de raccordement à la masse, la coque (1) formant enveloppe comportant des premiers moyens (7) de positionnement de la plaquette de circuits imprimés (4) qui comporte elle-même des conformations (8) qui corresponde à ces moyens (7), si bien qu'ainsi la plaquette de circuits imprimés (4), susceptible d'être disposée sur la coque (1) formant enveloppe, peut être positionnée par rapport à celle-ci, caractérisé en ce que
a) la coque (1) formant enveloppe comporte des seconds moyens (9) de positionnement de la pièce (6) de raccordement à la masse,
b) que des troisièmes moyens (10) sont prévus pour la fixation de la pièce (6) de raccordement à la masse sur la coque (1) formant enveloppe,
c) que les connecteurs à fiches (5) situés sur la plaquette de circuits imprimés (4) sont mis en place dans une position déterminée par rapport aux conformations (8) de celle-ci,
d) et, à une certaine, distance des connecteurs à fiches (5), le module (3) étant assemblé, il est prévu un élément de support (11), appartenant à la coque (1) formant enveloppe que est adaptée à une pièce antagoniste située sur un support en matière plastique qui constitue une partie du support de modules.

2. Module selon la revendication 1, caractérisé en ce que la coque (10) formant enveloppe présente des grilles d'aération (12) sur les côtés étroits qui se raccordent à angle droit au côté de branchement du module (3).

3. Module selon la revendication 1 ou 2, caractérisé en ce que les moyens (7, 9), ainsi que, le cas échéant, l'élément de support (11) sont issus de la coque (1) formant enveloppe ou de la pièce recouvrement (2).

4. Module selon l'une des revendications précédentes, caractérisé on ce que les premiers moyens de positionnement de la plaquette de circuits imprimés (4) sont réalisés sous la forme de boulons de centrage (7) des plaquettes de circuits imprimés et que les conformations correspondantes de la plaquette de circuits imprimés (4) sont des trous (8).

5. Module selon l'une des revendications précédentes, caractérisé en ce que les deuxièmes moyens de positionnement de la pièce (4) de raccordement à la masse sont réalisés sous la forme de boulons de centrage (9) s'écartant de la paroi intérieure de la coque (1) formant enveloppe, perpendiculairement à la paroi intérieure, et en ce qu'une échancrure (15) adaptée à la forme de la pièce (6) de raccordement à la masse est prévue dans la coque (1) formant enveloppe.

6. Module selon la revendication 4 ou 5, caractérisé en ce que les boulons de centrage (7) de plaquettes de circuits imprimés servent également de boulons de centrage (9) en vue de centrage de la pièce (6) de raccordement à la masse.

7. Module selon l'une des revendications précédentes, caractérisé en ce que les troisièmes moyens de fixation de la pièce (6) de raccordement à la masse peuvent être encliquetés sur cette saillie (10) prévue dans une cavité (16) de forme correspondante.

8. Module selon l'une des revendications précédentes, caractérisé en ce que l'élément de support est réalisé sous la forme de gradins (11) en forme de gouttes.

9. Module selon l'une des revendications précédentes, caractérisé en ce qu'en plus des gradins (11), la coque (1) formant enveloppe présente du côté du branchement du module (3), une barrette (17) qui est prévue à une distance définie par rapport aux connexions à fiche (5) du module (3).

10. Module selon l'une des revendications précédentes, caractérisé en ce que la plaquette de circuits imprimés (4) située dans le module (3) est entourée par une tôle métallique (20, 21) qui est reliée électriquement, comme la masse de la plaquette de circuits imprimés (4), à la pièce (6) de raccordement à la masse.

11. Module selon l'une des revendications précédentes, caractérisé en ce que sur la paroi intérieure de la coque (1) formant enveloppe sont prévus des tenons de centrage (19) susceptibles d'être comprimés, à l'aide desquels une première tôle de protection peut être positionnée au moyen de trous forés correspondants.

12. Module selon la revendication 11, caractérisé en ce que sur le côté de la plaquette de circuits imprimés (4) qui est situé à l'opposé de la première tôle (20) est prévue une deuxième tôle de protection (21), le module étant à l'état complètement monté, les tôles de protection (20, 21) étant coudées du côté situé à l'opposé du côté de branchement et les surfaces des tôles de protection coudées se chevauchant au moins partiellement.

13. Module selon la revendication 12, caractérisé en ce que la deuxième tôle de protection (21) est fixée à la plaquette de circuits imprimés (4) et présente dans sa surface coudée dos échancrures (36) et des trous (37), les échancrures ayant des dimensions qui correspondent aux cols métalliques (39) de fiches (38) disposées du côté frontal sur la plaquette de circuits imprimés (4) et soudés à celle-ci, et la tôle (21) de protection pouvant être vissée au col métallique (39) par les trous.

14. Module selon l'une des revendications précédentes, caractérisé en ce que la pièce de raccordement à la masse est réalisée sous la forme d'un étrier (6) de mise à la terre, coudé à angle droit, qui présente un trou de positionnement (22) adapté au boulon de centrage (9), un trou de fixation (23) ainsi que des trous filetés (24) par l'intermédiaire desquels les tôles de protection (20, 21) peuvent être vissées.

15. Module selon l'une des revendications précédentes, caractérisé en ce que la coque (1) formant enveloppe présente sur le côté situé vers l'espace intérieur du module (3) des points de support (25) sur lesquels la plaquette de circuits imprimés (4) peut être disposée sur l'une de ses deux faces en vue de son montage, en ce que les points de support(25) présentent un écart défini par rapport à la surface extérieure de la coque (1) formant enveloppe et que dans chaque cas une surface (26) de la coque (1 formant enveloppe, le module (3) se trouvant à l'état monté s'applique sur une surface (26) correspondante, située en face d'elle, de la pièce de recouvrement (2).

16. Module selon l'une des revendications précédentes, caractérisé en ce que la coque (1) et la pièce de recouvrement (2) comportent des surfaces (26) qui sont à une distance définie de la face extérieure de la coque (1) et en ce que, lorsque le module est monté, une surface (26) de le coque (1) s'applique sur une surface (26) correspondante opposée de le pièce de recouvrement (2).

17. Module selon l'une des revendications précédentes, caractérisé en ce que la coque (1) formant enveloppe présente dans des plans parallèles à sa paroi extérieure, à distance définie de celle-ci, des boulons de centrage (7) de plaquettes de circuits imprimés et des surfaces (26), par l'intermédiaire desquels, en plus de la plaquette de circuits imprimés (4), une autre plaquette de circuits imprimés (27) peut être positionnée et vissée au moyen de trous ménagés à des emplacements correspondants, la pièce de recouvrement (2) pouvant être vissée directement sur la coque (1) formant enveloppe par l'intermédiaire de quelques unes des surfaces (26).

18. Module selon l'une des revendications précédentes, caractérisé en ce que le module (3) est ouvert du coté situé à l'opposé de son côté de branchement.

19. Module selon la revendication 18, caractérisé en ce que du côté ouvert situé à l'opposé du côté de branchement du module (3), un capot frontal (28) peut être enfiché.

20. Module selon la revendication 19, caractérisé en ce que le capot frontal (28) présente sur ses bords longitudinaux des dents (29) aplaties en direction de l'extérieur, qui peuvent être amenées en contact avec les parois de la coque (1) formant enveloppe et la pièce de recouvrement (2).

21. Module selon la revendication 20, caractérisé on ce que la longueur des dents (29) diminue à partir des côtés étroits du capot frontal (28), jusqu'au milieu des bords longitudinaux.

22. Module selon la revendication 21, caractérisé en ce que le capot frontal (28) comporte une partie formant un décrochement et en ce que la partie avant en retrait présente au moins une échancrure (30) par laquelle au moins une fiche (38) soudée sur la plaquette de circuits imprimés (4) peut être contactée.

23. Module selon la revendication 22, caractérisé en ce qu'il est prévu un capot (33) de dimensions adaptées à l'espace formant un décrochement.

24. Module selon l'une des revendications précédentes, caractérisé en ce que la coque (1) formant enveloppe et la pièce de recouvrement (2) présentent des surfaces (31) faisant saillie en direction du côté de branchement du module (3) et formant un tablier pour celui-ci.

25. Module selon l'une des revendications précédentes, caractérisé en ce que du côté de branchement, le module (3) présente un élement de codage (32) pour lequel un élément antagoniste adapté est prévu sur le support de modules, à un emplacement correspondant.

26. Module selon l'une des revendications précédentes, caractérisé en ce que celui-ci présente au moins un boulon fileté (35) pour sa fixation au support de modules.
